# EUROPÄISCHE PATENTSCHRIFT

(11) **EP 0 591 476 B1**
(45) Veröffentlichungstag und Bekanntmachung des Hinweises auf die Patenterteilung: **18.12.1996**
(21) Anmeldenummer: 93901021.1
(22) Anmeldetag: 10.06.1992
(51) Int. Cl.: H01L 27/02

(54) **MONOLITHISCH INTEGRIERTE SCHALTUNGSANORDNUNG**
MONOLITHICALLY INTEGRATED CIRCUIT
CIRCUIT INTEGRE MONOLITHIQUE

(30) Priorität: 20.06.1991 DE 4120394
(43) Veröffentlichungstag der Anmeldung: 13.04.1994
(73) Patentinhaber: ROBERT BOSCH GMBH, 70442 Stuttgart (DE)
(72) Erfinder: DENNER, Volkmar, D-7417 Pfullingen (DE); TROELENBERG, Wolfgang, D-7410 Reutlingen (DE); BRAUCHLE, Peter, D-7401 Nehren (DE); FOX, William-Neil, D-7410 Reutlingen (DE); DAVIES, Neil, D-7408 Kusterdingen (DE)
(86) Internationale Anmeldenummer: DE9200479
(87) Internationale Veröffentlichungsnummer: WO9300709

(56) Entgegenhaltungen:
- EP-A- 0 271 942
- EP-A- 0 318 297
- US-A- 4 893 212
- US-A- 5 023 692
- PATENT ABSTRACTS OF JAPAN vol. 10, no. 332 (E-453)12. November 1986 &JP - A - 61 137 368.

## Beschreibung

### Stand der Technik

Die Erfindung betrifft eine monolithisch integrierte Schaltungsanordnung nach der Gattung des Hauptanspruchs.

Es sind bereits MOSFET-Leistungstransistoren bekannt, die aus einer Vielzahl zueinander parallelgeschalteter Teiltransistoren (Zellen) bestehen, die in einem einzigen, einkristallinen, aus Silizium bestehenden Halbleiterkörper untergebracht sind. Die Gesamtheit aller Teiltransistoren kann dabei von einer Diffusionszone umschlossen sein, die als Schutzring um den Zellverband des MOSFET-Leistungstransistors gelegt ist.

Andererseits sind bereits Schutzschaltungen bekanntgeworden, die zum Schutz der MOSFET-Leistungstransistoren, insbesondere zum Schutz dieser Transistoren gegen Kurzschluß und Überspannungen, dienen. Die die Schutzfunktion übernehmenden aktiven und/oder passiven Schaltungseinheiten sind dabei als diskrete Bauelemente dem MOSFET-Leistungstransistor extern zugeschaltet.

Das Dokument US-A-4 893 212 offenbart eine Schaltungsanordnung bestehend aus einem vertikalen MOSFET Leistungstransistor, einem bipolaren Transistor und einem Schutzring.

Eine monolithisch integrierte Schaltungsanordnung gemäß der Erfindung ist in Anspruch 1 definiert. Weitere Ausführungsformen sind in den Unteransprüchen 2-15 definiert.

### Zeichnung

Anhand der Zeichnung wird die Erfindung näher erläutert. Es zeigen:
Figur 1 einen MOSFET-Leistungstransistor mit einer Schutzschaltung, die den MOSFET-Leistungstransistor im Falle von Überlast oder Kurzschluß abschaltet, im Schaltbild,
Figur 2 ein Schnittbild durch einen scheibenförmigen einkristallinen Halbleiterkörper aus Silizium, der die Schaltungsanordnung nach Figur 1 in monolithisch integrierter Form gemäß einem ersten Ausführungsbeispiel der Erfindung enthält, teilweise abgebrochen,
Figur 3 ein zweites Ausführungsbeispiel einer erfindungsgemäßen monolithisch integrierten Ausgestaltung der Schaltungsanordnung nach Figur 1, im Schnitt, teilweise abgebrochen,
Figur 4 eine Weiterbildung der Schaltungsanordnung nach Figur 1,
Figur 5 ein Schnittbild einer monolithisch integrierten Ausgestaltung der Schaltungsanorndung nach Figur 4 als drittes Ausführungsbeispiel einer monolithisch integrierten Schaltungsanordnung gemäß der Erfindung.

### Beschreibung der Erfindung

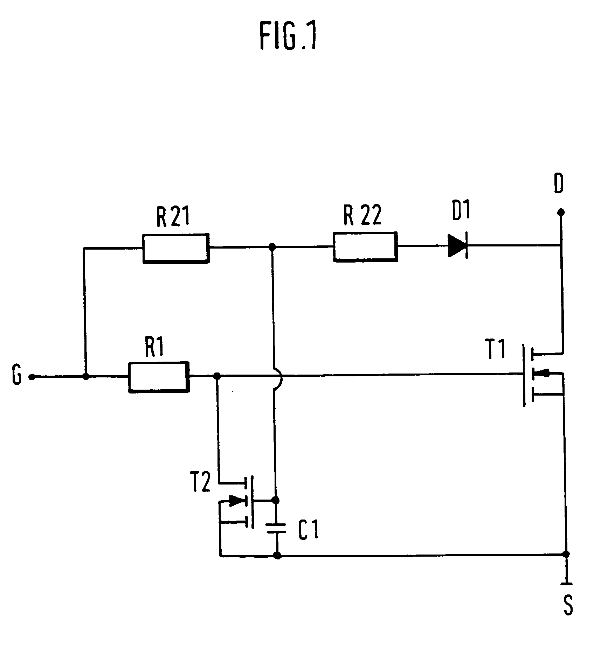

Bei dem in Figur 1 dargestellten Schaltbild ist mit T1 ein aus einer Vielzahl zueinander parallelgeschalteter Teiltransistoren bestehender n-Kanal-MOSFET-Leistungstransistor, mit S seine Sourceanschlußklemme und mit D seine Drainanschlußklemme bezeichnet. Die Eingangsklemme G des MOSFET-Leistungstransistors T1 ist über einen ersten ohmschen Widerstand R1 mit seinem Polysilizium-Gate verbunden.

Ein n-Kanal-MOSFET-Hilfstransistor T2 ist mit seiner Sourceelektrode an die Sourceelektrode des MOSFET-Leistungstransistors T1 angeschlossen. Die Drainelektrode des MOSFET-Hilfstransistors T2 ist an das Polysilizium-Gate des MOSFET-Leistungstransistors T1 angeschlossen. Das Polysilizium-Gate des MOSFET-Hilfstransistors T2 ist einerseits über einen zweiten ohmschen Widerstand R21 mit der Eingangsklemme G und andererseits über die Reihenschaltung eines dritten ohmschen Widerstands R22 und einer Schutzdiode D1 mit der Drainanschlußklemme D des MOSFET-Leistungstransistors T1 verbunden. Des weiteren ist das Polysilizium-Gate des MOSFET-Hilfstransistors T2 mit dem einen Belag einer Kapazität C1 verbunden, deren anderer Belag an die Sourceelektrode des MOSFET-Hilfstransistors T2 angeschlossen ist.

Die Wirkungsweise der Schaltungsanordnung nach Figur 1 ist folgende:

Im ausgeschalteten Zustand liegt zwischen der Eingangsklemme G und der Sourceanschlußklemme S die Spannung UGS = 0. Zwischen der Drainanschlußklemme D und der Sourceanschlußklemme S liegt die Betriebsspannung. Da die Diode D1 in Sperrichtung gepolt ist, werden das Polysiliziumgate des MOSFET-Hilfstransistors T2 und die Kapazität C1 entladen. Die Gate-Source-Spannung des MOSFET-Hilfstransistors T2 ist UGS2 = 0.

Wird die Anordnung eingeschaltet, das heißt UGS wird auf typisch + 5 Volt erhöht, so wird die Gatekapazität des MOSFET-Leistungstransistors T1 aufgeladen und damit steigt die Gate-Source-Spannung des MOSFET-Leistungstransistors T1 (UGS1). Gleichzeitig werden über den Widerstand R21 das Gate des MOSFET-Hilfstransistors T2 und die Kapazität C1 aufgeladen. Damit steigt auch UGS2. Steigt UGS2 über die Schwellspannung des MOSFET-Hilfstransistors T2, so wird der Einschaltvorgang des MOSFET-Leistungstransistors T1 unterbrochen und die Schaltung läßt sich nicht einschalten. Deshalb muß die Zeitkonstante für das Ansteigen von UGS2 größer gewählt werden als die für den MOSFET-Leistungstransistors T1. Unter dieser Bedingung ergibt sich folgender Einschaltvorgang: UGS1 steigt über die Schwellspannung des MOSFET-Leistungstransistors T1 und es fließt über diesen Transistor ein Strom I. Die Spannung UDS ergibt sich in diesem Zustand als UDS = RDS (on) I. Ist dieser Wert klein genug, so wird ein Stromfluß vom Gate des MOSFET-Hilfstransistors T2 über den Widerstand R22 und die Diode D1 zum Drainanschluß D einsetzen und der Ladevorgang des Gates des MOSFET-Hilfstransistors T2 wird abgebrochen. Damit wird der MOSFET-Hilfstransistor T2 nicht eingeschaltet und die gesamte Schaltung ist im Einzustand.

Im normalen Einzustand wird über den Strompfad G-R21-R22-D1-D eine Spannung UGS2 knapp unter der Schwellspannung des MOSFET-Hilfstransistors T2 eingestellt. Steigt nun der Strom I im MOSFET-Leistungstransistor T1, so steigt der Spannungsabfall am RDS (on) und damit das Potential des Drainanschlusses D. Als Folge steigt die Spannung UGS2. Beim Überschreiten der Schwellspannung des MOSFET-Hilfstransistors T2 wird der Hilfstransistor T2 eingeschaltet und damit die Spannung UGS1 erniedrigt. Dadurch steigt der RDS (on) des MOSFET-Leistungstransistors T1 und UDS steigt an. Dadurch wird der Effekt verstärkt und UGS2 steigt weiter. Dies führt zur vollständigen Abschaltung des MOSFET-Leistungstransistors T1. Ein Wiedereinschalten ist nur möglich, wenn die externe Spannung UGS erniedrigt wird, um die Gatekapazität des MOSFET-Hilfstransistors T2 und den Kondensator C1 zu entladen. Damit ist der normale Auszustand wieder erreicht.

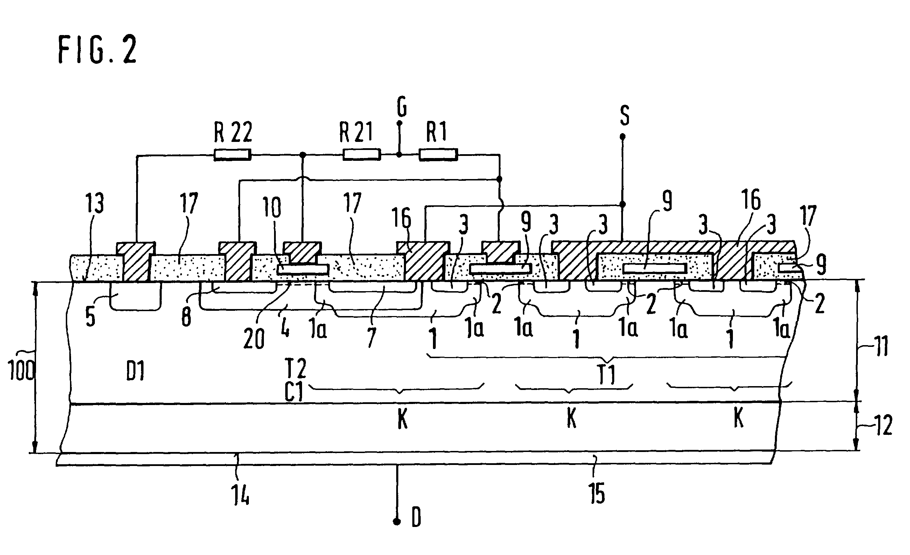

In Figur 2 ist ein Schnitt durch die monolithisch integrierte Schaltungsanordnung nach Figur 1 dargestellt. Ein scheibenförmiger, aus einkristallinem Silizium bestehender Halbleiterkörper 100 enthält eine n⁻-leitende Epitaxialschicht 11, die auf ein n⁺-leitendes, aus einkristallinem Silizium bestehendes Substrat 12 aufgebracht ist. Der aus dem Substrat 12 und der Epitaxialschicht 11 bestehende Halbleiterkörper 100 weist somit an seiner Oberseite eine erste Hauptoberfläche 13 und an seiner Unterseite eine zweite Hauptoberfläche 14 auf. Auf die zweite Hauptoberfläche 14 des Halbleiterkörpers 100 ist eine Metallisierung 15 aufgebracht, die den Drainanschluß D des vertikalen MOSFET-Leistungstransistors T1 bildet.

Der rechte Teil des Schnittbildes der Figur 2 zeigt den an sich bekannten, in Zellen unterteilten Aufbau des MOSFET-Leistungstransistors T1, bei dem die Dichte der Zellen bis zu 2,1 Millionen Zellen pro Quadratinch betragen kann. Der mittlere und der linke Teil zeigt den Randbereich, in welchem die peripheren Schaltungselemente untergebracht sind.

Die Zellen des MOSFET-Leistungstransistors T1 enthalten p-dotierte Körperzonen K, die jeweils durch Ineinanderdiffundieren einer p⁺-dotierten kleinflächigeren Zone 1 und einer p⁻-dotierten großflächigeren Zone la gebildet sind. Die kleinflächigere Zone 1 hat dabei jeweils eine höhere Eindringtiefe als die großflächigere Zone 1a. In die so gebildeten p-dotierten Körperzonen K sind jeweils innerhalb des hochdotierten Zentralbereichsn⁺⁺-dotierte Sourcezonen 3 derart eindiffundiert, daß der niedrig dotierte Randbereich la der Körperzonen K freibleibt und bis an die erste Hauptoberfläche 13 des Halbleiterkörpers 100 reicht. In diesem Randbereich der Körperzonen K wird der Leitfähigkeitskanal 2 in jeder Zelle des MOSFET-Leistungstransistors T1 dadurch gebildet, daß diesem Randbereich jeweils ein Teil 9 des Polysilizium-Gates des genannten Transistors T1 gegenübersteht. Die Teile 9 des Polysilizium-Gates des MOSFET-Leistungstransistors T1 dienen bei der Herstellung der Diffusionszonen 1, 1a und 3 als Maske und sind deshalb innerhalb des Zellverbandes des MOSFET-Leistungstransistors T1 gitterartig und damit elektrisch leitend miteinander verbunden. Innerhalb jeder Zelle des MOSFET-Leistungstransistors T1 sind die Sourcezonen 3 jeweils mit den Körperzonen K mittels einer gemeinsamen Metallisierung 16 kurzgeschlossen, die zur Bildung dieses Kurzschlusses im Zentralbereich jeder Körperzone K sich bis an die erste Hauptoberfläche 13 des Halbleiterkörpers 100 erstreckt und die einzelnen Teile 9 des Polysiliziumgates unter Zwischenschaltung einer Siliziumdioxidschicht 17 umgreift. Diese gemeinsame Metallisierung 16 bildet die Sourceelektrode S des MOSFET-Leistungstransistors T1.

Um das gesamte Zellenfeld des MOSFET-Leistungstransistors T1 ist eine als Schutzring dienende ringförmige Wanne 4 eindiffundiert, die die Randstruktur des MOSFET-Leistungstransistors T1 bildet, um die Sperrspannung zwischen den Elektroden S und D aufzunehmen. Die ringförmige Wanne 4 ist p-leitend. Ihre Dotierungskonzentration liegt zwischen der Dotierungskonzentration des hochdotierten Zentralbereichs 1 und der Dotierungskonzentration des niedrig dotierten Randbereichs la der Körperzonen K. Entsprechendes gilt auch für die Eindringtiefe der ringförmigen Wanne 4. Diese liegt zwischen den Eindringtiefen der beiden genannten Bereiche 1 und 1a der Körperzonen K.

Figur 2 zeigt die ringförmige Wanne 4 in einem Bereich, wo sie gegenüber den übrigen Bereichen der Wanne stark verbreitert ist. Dieser verbreiterte Bereich der Wanne 4 dient zur Aufnahme des lateralen n-Kanal-MOSFET-Hilfstransistors T2. Er wird gebildet von den stark n-dotierten Zonen 7 als Source und 8 als Drain sowie von der Polysiliziumschicht 10 als Gate. Die n⁺⁺-dotierten Zonen 7 und 8 sind dabei mit dem gleichen Diffusionsprozeß hergestellt wie die Sourcezonen 3 des MOSFET-Leistungstransistors T1. Wie aus Figur 2 ersichtlich, überlappt sich der Schutzring 4 in seinem verbreiterten Bereich, der. die Körperzone des MOSFET-Hilfstransistors T2 bildet, mit der Körperzone K der an ihn angrenzenden äußersten Zelle des MOSFET-Leistungstransistors T1 derart, daß seine Sourcezone 7 vollständig in die genannte Körperzone K eingebettet ist und daß seine Drainzone 8 sich im Bereich außerhalb der genannten Körperzone K befindet. Die Überlappung ist dabei des weiteren so ausgeführt, daß der schwach dotierte Randbereich la der genannten Körperzone K des MOSFET-Leistungstransistors T1 sich bis in den Kanalbereich des MOSFET-Hilfstransistors T2 erstreckt. Dadurch wird erreicht, daß die Schwellspannung des MOSFET-Hilfstransistors T2 von beiden Gebieten 4 und la sowie der Epitaxialschicht 11 bestimmt wird und damit höher ist als die Schwellspannung des MOSFET-Leistungstransistors T1, die nur durch das Diffusionsgebiet la und die Epitaxialschicht 11 bestimmt wird.

Gleichzeitig mit dem Schutzring 4 ist in den einkristallinen Halbleiterkörper 100 eine weitere p-leitende Zone 5 eindiffundiert, deren pn-Übergang mit der Epitaxialschicht 11 die Schutzdiode D1 nach Figur 1 bildet.

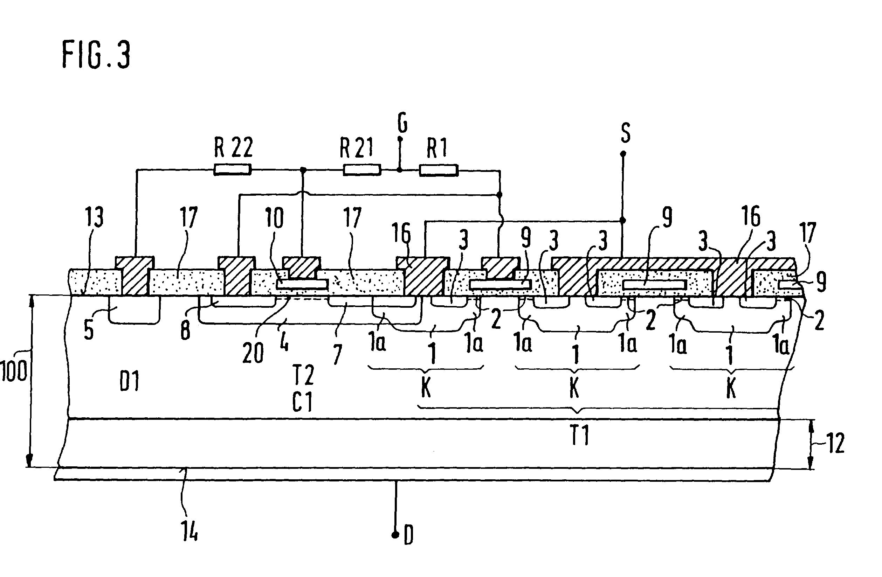

Figur 3 zeigt ein weiteres Ausführungsbeispiel einer erfindungsgemäßen monolithisch integrierten Schaltungsanordnung, bei dem ebenfalls die ringförmige Wanne 4 in einem verbreiterten Bereich einen lateralen n-Kanal-MOSFET-Hilfstransistor T2 enthält, dessen Sourcezone wieder mit 7 und dessen Drainzone wieder mit 8 und dessen Polysiliziumgate wieder mit 10 bezeichnet ist. Der verbreiterte Bereich des Schutzrings 4 überlappt sich auch hier wieder mit der Körperzone K der an ihn angrenzenden äußersten Zelle des MOSFET-Leistungstransistors T1. Die Sourcezone 7 ist hier jedoch nur teilweise in die genannte Körperzone K des MOSFET-Leistungstransistors T1 eingebettet. Der schwach dotierte Randbereich la der genannten Körperzone K erstreckt sich hier nicht bis in den unter dem Polysiliziumgate 10 liegenden Kanalbereich des MOSFET-Hilfstransistors T2, sondern endet bereits im Bereich der Sourcezone 7. Dadurch wird erreicht, daß die Schwellspannung des MOSFET-Hilfstransistors T2 nur durch das Gebiet 4 und die Epitaxialschicht 11 bestimmt wird. Damit kann für den MOSFET-Hilfstransistor T2 eine Schwellspannung realisiert werden, die kleiner oder größer ist als die Schwellspannung des MOSFET-Leistungstransistors T1.

Bei den beiden Ausführungsbeispielen nach den Figuren 2 und 3 wird die in Figur 1 mit C1 bezeichnete Kapazität dadurch realisiert, daß das zum MOSFET-Hilfstransistor T2 gehörende Polysiliziumgate 10 sich im Bereich des Schutzrings 4 in einer in den Figuren 2 und 3 nicht dargestellten Weise über den Kanalbereich des MOSFET-Hilfstransistors T2 hinaus erstreckt, beispielsweise in eine Richtung senkrecht zur Zeichenebene der Figuren 2 und 3.

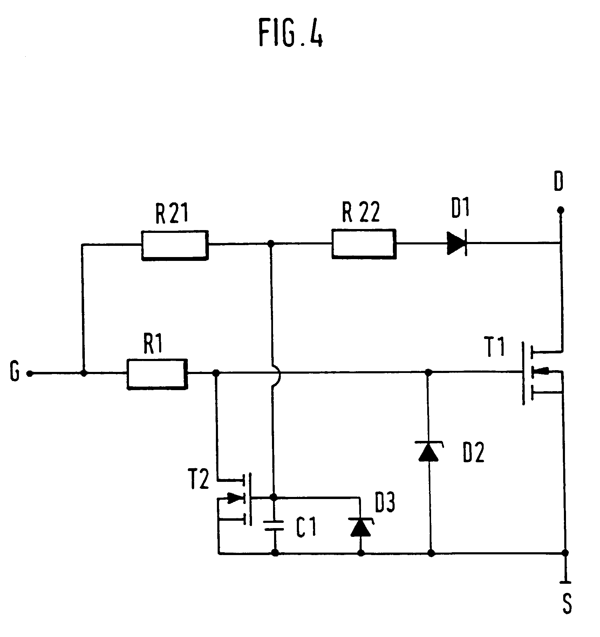

In Figur 4 ist eine weitere erfindungsgemäße Schaltungsanordnung dargestellt. Sie zeigt über die Schaltungselemente der Figur 1 hinaus eine erste Zenerdiode D2 zum Schutz des Gates des MOSFET-Leistungstransistors T1 gegen Überspannungen und eine zweite Zenerdiode D3 zum Schutz des Gates des MOSFET-Hilfstransistors T2 gegen Überspannungen, wobei die Kathoden der beiden Zenerdioden D2, D3 jeweils an das zu schützende Gate und ihre Anoden jeweils an die mit Masse verbundene Sourceelektrode S des MOSFET-Leistungstransistors T1 angeschlossen sind.

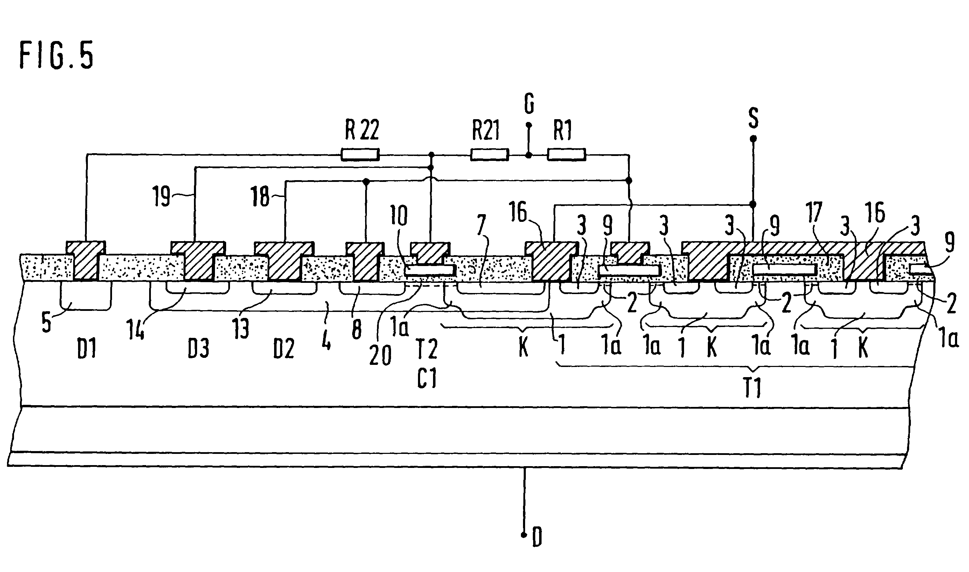

In Figur 5 ist dargestellt, wie die beiden Zenerdioden D2 und D3 monolithisch integriert werden. Die erste Zenerdiode D2 wird durch eine weitere Zone 13 mit dem Leitfähigkeitstyp des Halbleiterkörpers, aber erhöhter Störstellenkonzentration, gebildet, die in den Schutzring 4 eindiffundiert ist, wobei die Zone 13 die Kathode der ersten Zenerdiode D2 bildet und über die bei 18 angedeutete Verbindungsleitung mit dem Polysiliziumgate 9 des MOSFET-Leistungstransistors T1 verbunden ist. Die zweite Zenerdiode D3 wird durch eine weitere Zone 14 mit dem Leitfähigkeitstyp des Halbleiterkörpers, aber erhöhter Störstellenkonzentration, gebildet, die in den Schutzring 4 eindiffundiert ist, wobei die Zone 14 die Kathode der zweiten Zenerdiode D3 bildet und über die bei 19 angedeutete Verbindungsleitung mit dem Polysiliziumgate 10 des MOSFET-Hilfstransistors T2 verbunden ist. Der Schutzring 4 bildet für beide Zenerdioden D2, D3 die gemeinsame Anode, wobei der Schutzring 4 über die gemeinsame Sourcemetallisierung 16 des MOSFET-Leistungstransistors T1 mit Masse verbunden ist.

Die Erfindung ist nicht auf die anhand der Zeichnung beschriebenen Ausführungsbeispiele beschränkt. Insbesondere können außer den Schaltungselementen T2, D2 und D3 noch weitere periphere Schaltungselemente, insbesondere die Widerstände R1, R21 und R22 in dem Schutzring 4 integriert sein, wobei die genannten Widerstände als n⁺⁺-dotierte diffundierte Widerstände ausgeführt sein können. Alternativ dazu können diese Widerstände aber auch aus Polysilizium bestehen und in der Ebene der Polysiliziumgates 9 und 10 untergebracht und gleichzeitig mit diesen Gates hergestellt sein.

Im Rahmen der Erfindung liegt es auch, den MOSFET-Leistungstransistor T1 als sogenannten SENSEFET auszubilden, das heißt, einige seiner Zellen mit einem separaten Sourceanschluß zu versehen, der mit der gemeinsamen Sourcemetallisierung 16 der verbleibenden Zellen keine elektrisch leitende Verbindung hat.

Auch ist es möglich, Leiterbahnen der Verbindungsmetallisierung und/oder Widerstände so auszubilden und anzuordnen, daß durch deren gezieltes Durchbrennen ein Abgleich der Schaltung möglich ist.

Der besondere Vorteil der vorliegenden monolithisch integrierten Schaltungsanordnung besteht im Vergleich zu der bekannten diskreten Beschaltung erfindungsgemäß darin, daß Fertigungsstreuungen sich auf die einzelnen Schaltungselemente der integrierten Schaltung in gleicher Weise auswirken. So wird ein weitgehendes "Tracking" der Schwellspannungen erreicht. Weiterhin wird der Temperaturkoeffizient des RDS (on) und der Widerstände R21 und R22 in der Weise ausgenützt, daß die Überlasterkennung bei hoher Chiptemperatur früher erfolgt als bei tiefer Chiptemperatur. Dadurch wird ein Schutz der Schaltung vor zu hohen Betriebstemperaturen erreicht.

Im Unterschied zu den anhand der Zeichnung beschriebenen Ausführungsbeispielen können alle Halbleitergebiete auch vom entgegengesetzten Leitfähigkeitstyp sein, das heißt n- und p-leitende Gebiete können vertauscht sein. Auf diese Weise kann ein erfindungsgemäßer kurzschlußfester p-Kanal-MOSFET-Leistungstransistor realisiert werden.

## Patentansprüche

1. Monolithisch integrierte Schaltungsanordnung, die in einem eine erste und eine zweite Hauptoberfläche aufweisenden scheibenförmigen einkristallinen, aus Silizium bestehenden Halbleiterkörper (100) eines ersten Leitfähigkeitstyps untergebracht ist, mit einem vertikalen MOSFET-Leistungstransistor (T1), bei dem die Drainzone sich von der ersten bis zur zweiten Hauptoberfläche erstreckt und an der zweiten Hauptoberfläche mit einem durchgehenden Drainanschluß (D) versehen ist, bei dem von der ersten Hauptoberfläche (13) her in den Halbleiterkörper (100) mindestens eine Körperzone (K) eines zweiten, zum Halbleiterkörper entgegengesetzten Leitfähigkeitstyps eindiffundiert ist, bei dem in die mindestens eine Körperzone (K) von der ersten Hauptoberfläche (13) her jeweils mindestens eine Sourcezone (3) vom Leitfähigkeitstyp des Halbleiterkörpers, aber erhöhter Störstellenkonzentration eindiffundiert ist und bei dem mindestens ein Polysiliziumgate (9) zur Bildung des Leitfähigkeitskanals (2) vorgesehen ist, und mit einem den MOSFET-Leistungstransistor (T1) umschließenden Schutzring (4) vom Leitfähigkeitstyp der mindestens einen Körperzone (K), wobei in den Schutzring (4) von der ersten Hauptoberfläche (13) her weitere Zonen (7, 8; 13; 14) zur Ausbildung mindestens eines peripheren Schaltungselements (T2; D2; D3;R1;R21;R22) eindiffundiert sind, dadurch gekennzeichnet, daß als pheripheres Schaltungselement mindestens ein lateraler MOSFET-Hilfstransistor (T2) vorgesehen ist, wobei der Schutzring (4) als Körperzone für den lateralen MOSFET-Hilfstransistor (T2) dient, wobei ferner die Sourcezone (7) und die Drainzone (8) des MOSFET-Hilfstransistors (T2) die gleiche Dotierung der ersten Leitfähigkeitstyps wie die mindestens eine Sourcezone (3) des MOSFET-Leistungstransistors (T1) aufweisen und im Schutzring (4) zueinander benachbart ausgebildet sind und wobei die Gateelektrode (10) des MOSFET-Hilfstransistors (T2) sich über den zwischen Sourcezone (7) und Drainzone (8) liegenden Bereich des Schutzrings (4) erstreckt, in welchem sich beim Betrieb der Leitfähigkeitskanal (20) des MOSFET-Hilfstransistors (T2) an der ersten Hauptoberfläche (13) des Halbleiterkörpers (100) bildet.

2. Schaltungsanordnung nach Anspruch 1, dadurch gekennzeichnet, daß die Körperzone (K) des MOSFET-Leistungstransistors (T1) durch eine kleinflächigere Zone (1) und eine großflächigere Zone (1a) gebildet ist, wobei die kleinflächigere Zone (1) eine höhere und die großflächigere Zone (1a) eine niedrigere Dotierungskonzentration als die Schutzzone (4) hat und wobei die beiden genannten verschiedenflächigen Zonen (1, 1a), die sich zu der Körperzone (K) überlagern, so ineinander hineindiffundiert sind, daß die großflächigere Zone (1a) allseitig über die kleinflächigere Zone (1) übersteht.

3. Schaltungsanordnung nach Anspruch 1 oder 2, dadurch gekennzeichnet, daß der MOSFET-Leistungstransistor (T1) aus einer Vielzahl zueinander parallelgeschalteter Teiltransistoren besteht, von denen jeder eine Körperzone (K) und mindestens eine Sourcezone (3) hat, alle Teiltransistoren aber eine gemeinsame Drainzone haben, die durch den verbleibenden, von den Körperzonen (K) nicht beanspruchten, durch den Schutzring (4) abgegrenzten Bereich des Halbleiterkörpers (100) gebildet wird.

4. Schaltungsanordnung nach Anspruch 1, dadurch gekennzeichnet, daß der Schutzring (4) in demjenigen Bereich, in welchem er den MOSFET-Hilfstransistor (T2) aufnimmt, sich mit der Körperzone (K) der an ihn angrenzenden äußersten Zelle des MOSFET-Leistungstransistors (T1) überlappt.

5. Schaltungsanordnung nach Anspruch 4, dadurch gekennzeichnet, daß die Sourcezone (7) des MOSFET-Hilfstransistors (T2) vollständig in die Körperzone (K) der an ihn angrenzenden äußersten Zelle des MOSFET-Leistungstransistors (T1) eingebettet ist und daß die Drainzone (8) des MOSFET-Hilfstransistors (T2) sich im Bereich außerhalb dieser Körperzone (K) befindet, so daß der Randbereich (la) der genannten Körperzone (K) des MOSFET-Leistungstransistors (T1) sich bis in den Kanalbereich des MOSFET-Hilfstransistors (T2) erstreckt.

6. Schaltungsanordnung nach Anspruch 4, dadurch gekennzeichnet, daß die Sourcezone (7) des MOSFET-Hilfstransistors (T2) teilweise in die sich mit dem Schutzring (4) überlappende Körperzone (K) der an ihn angrenzenden äußersten Zelle des MOSFET-Leistungstransistors (T1) eingebettet ist.

7. Schaltungsanordnung nach Anspruch 5 oder 6, dadurch gekennzeichnet, daß die Sourcezone (7) des MOSFET-Hilfstransistors (T2) mit der Sourcezone (3) der an ihn angrenzenden äußersten Zelle des MOSFET-Leistungstransistors (T1) und mit dem Schutzring (4) mittels der Sourcemetallisierung (S) des MOSFET-Leistungstransistors (T1) kurzgeschlossen ist.

8. Schaltungsanordnung nach Anspruch 7, dadurch gekennzeichnet, daß die Drainelektrode des MOSFET-Hilfstransistors (T2) einerseits direkt mit der Gateelektrode des MOSFET-Leistungstransistors (T1) und andererseits über einen ersten ohmschen Widerstand (R1) mit der Eingangsklemme (G) des MOSFET-Leistungstransistors (T1) verbunden ist, daß die Gateelektrode des MOSFET-Hilfstransistors (T2) einerseits über einen zweiten ohmschen Widerstand (R21) mit der genannten Eingangsklemme (G) und andererseits über eine Schutzdiode (D1) mit der Drainelektrode (D) des MOSFET-Leistungstransistors (T1) verbunden ist, daß die erste Elektrode der Schutzdiode (D1) durch den scheibenförmigen Halbleiterkörper und die zweite Elektrode der Schutzdiode (D1) durch eine von der ersten Hauptoberfläche her in den Halbleiterkörper (100) eindiffundierte weitere Zone (5) mit zum Halbleiterkörper (100) entgegengesetztem Leitfähigkeitstyp gebildet ist.

9. Schaltungsanordnung nach Anspruch 8, dadurch gekennzeichnet, daß die die zweite Elektrode der Schutzdiode (D1) bildende Zone (5) die gleiche Dotierung des zweiten Leitfähigkeitstyps wie die den Schutzring (4) bildende Zone aufweist.

10. Schaltungsanordnung nach Anspruch 8 oder 9, dadurch gekennzeichnet, daß eine erste Zenerdiode (D2) zum Schutz des Gates des MOSFET-Leistungstransistors (T1) gegen Überspannungen vorgesehen ist, daß zur Bildung der ersten Zenerdiode (D2) eine weitere Zone (13) mit dem Leitfähigkeitstyp des Halbleiterkörpers, aber erhöhter Störstellenkonzentration in den Schutzring (4) eindiffundiert ist, wobei die weitere Zone (13) die eine Elektrode und der Schutzring (4) die andere Elektrode der ersten Zenerdiode (D2) bildet.

11. Schaltungsanordnung nach einem der Ansprüche 8 bis 10, dadurch gekennzeichnet, daß eine zweite Zenerdiode (D3) zum Schutz des Gates des MOSFET-Hilfstransistors (T2) gegen Überspannungen vorgesehen ist, daß zur Bildung der zweiten Zenerdiode (D3) eine weitere Zone (14) mit dem Leitfähigkeitstyp des Halbleiterkörpers, aber erhöhter Störstellenkonzentration in den Schutzring (4) eindiffundiert ist, und daß die weitere Zone (14) die eine Elektrode und der Schutzring (4) die andere Elektrode der zweiten Zenerdiode (D3) bildet.

12. Schaltungsanordnung nach Anspruch 1, dadurch gekennzeichnet, daß der MOSFET-Leistungstransistor (T1) als SENSEFET-Leistungstransistor ausgebildet ist, indem mindestens einer seiner Teiltransistoren mit einem separaten Source-Anschluß versehen ist.

13. Schaltungsanordnung nach einem der Ansprüche 1 bis 12, dadurch gekennzeichnet, daß mindestens ein ohmscher Widerstand (R1, R21, R22) als diffundierter Widerstand in dem Schutzring (4) untergebracht ist und den Leitfähigkeitstyp des Halbleiterkörpers (100), aber eine erhöhte Störstellenkonzentration aufweist.

14. Schaltungsanordnung nach einem der Ansprüche 1 bis 13, dadurch gekennzeichnet, daß mindestens ein ohmscher Widerstand (R1, R21, R22) aus Polysilizium besteht und in der Ebene des Polysiliziumgates (9) des MOSFET-Leistungstransistors (T1) untergebracht ist.

15. Schaltungsanordnung nach einem der Ansprüche 1 bis 14, gekennzeichnet durch mindestens eine Kapazität (C1), deren einer Belag (10) aus Polysilizium besteht und in der Ebene des Polysiliziumgates (9) des MOSFET-Leistungstransistors (T1) untergebracht ist und deren anderer Belag mindestens teilweise durch den Schutzring (4) gebildet ist.

## Claims

1. Monolithically integrated circuit arrangement, 1 which is accommodated in a monocrystalline semiconductor body (100) of a first conductivity type, which semiconductor body is composed of silicon, is in the form of a wafer and has a first and a second main surface, having a vertical MOSFET power transistor (T1), in which the drain zone extends from the first to the second main surface and is provided with a continuous drain terminal (D) on the second main surface, in which at least one body zone (K) of a second conductivity type opposite to that of the semiconductor body is diffused into the semiconductor body (100) from the first main surface (13), in which in each case at least one source zone (3) having the conductivity type of the semiconductor body but an increased impurity concentration is diffused into the at least one body zone (K) from the first main surface (13), and in which there is provided at least one polysilicon gate (9) for forming the conductivity channel (2), and having a protective ring (4) which encloses the MOSFET power transistor (T1) and has the conductivity type of the at least one body zone (K), further zones (7, 8; 13; 14) for forming at least one peripheral circuit element (T2; D2; D3; R1; R21; R22) being diffused into the protective ring (4) from the first main surface (13), characterized in that at least one lateral MOSFET auxiliary transistor (T2) is provided as the peripheral circuit element, the protective ring (4) serving as body zone for the lateral MOSFET auxiliary transistor (T2), furthermore the source zone (7) and the drain zone (8) of the MOSFET auxiliary transistor (T2) having the same doping of the first conductivity type as the at least one source zone (3) of the MOSFET power transistor (T1) and being formed adjacent to one another in the protective ring (4), and the gate electrode (10) of the MOSFET auxiliary transistor (T2) extending over that region of the protective ring (4) which lies between the source zone (7) and drain zone (8) and in which, during operation, the conductivity channel (20) of the MOSFET auxiliary transistor (T2) is formed at the first main surface (13) of the semiconductor body (100).

2. Circuit arrangement according to Claim 1, characterized in that the body zone (K) of the MOSFET power transistor (T1) is formed by a smaller-area zone (1) and a larger-area zone (la), the smaller-area zone (1) having a higher doping concentration than the protective zone (4) and the larger-area zone (la) having a lower doping concentration than the protective zone (4), and the two abovementioned different-area zones (1, la), which are superposed to form the body zone (K), being diffused into one another in such a way that the larger-area zone (la) projects over the smaller-area zone (1) on all sides.

3. Circuit arrangement according to Claim 1 or 2, characterized in that the MOSFET power transistor (T1) consists of a multiplicity of transistor elements which are connected in parallel with one another and each of which has a body zone (K) and at least one source zone (3), but all of the transistor elements have a common drain zone which is formed by the remaining region of the semiconductor body (100), which region is not occupied by the body zones (K) and is delimited by the protective ring (4).

4. Circuit arrangement according to Claim 1, characterized in that, in that region in which it accommodates the MOSFET auxiliary transistor (T2), the protective ring (4) overlaps the body zone (K) of the outermost cell, adjoining the said transistor, of the MOSFET power transistor (T1).

5. Circuit arrangement according to Claim 4, characterized in that the source zone (7) of the MOSFET auxiliary transistor (T2) is completely embedded in the body zone (K) of the outermost cell, adjoining the said transistor, of the MOSFET power transistor (T1), and in that the drain zone (8) of the MOSFET auxiliary transistor (T2) is situated in the region outside this body zone (K), with the result that the edge region (la) of the said body zone (K) of the MOSFET power transistor (T1) extends right into the channel region of the MOSFET auxiliary transistor (T2).

6. Circuit arrangement according to Claim 4, characterized in that the source zone (7) of the MOSFET auxiliary transistor (T2) is partially embedded in the body zone (K), overlapping the protective ring (4), of the outermost cell, adjoining the said transistor, of the MOSFET power transistor (T1).

7. Circuit arrangement according to Claim 5 or 6, characterized in that the source zone (7) of the MOSFET auxiliary transistor (T2) is short-circuited with the source zone (3) of the outermost cell, adjoining the said transistor, of the MOSFET power transistor (T1) and with the protective ring (4) by means of the source metallization layer (S) of the MOSFET power transistor (T1).

8. Circuit arrangement according to Claim 7, characterized in that the drain electrode of the MOSFET auxiliary transistor (T2) is connected, on the one hand, directly to the gate electrode of the MOSFET power transistor (T1) and, on the other hand, via a first non-reactive resistor (R1) to the input terminal (G) of the MOSFET power transistor (T1), in that the gate electrode of the MOSFET auxiliary transistor (T2) is connected, on the one hand, via a second non-reactive resistor (R21) to the said input terminal (G) and, on the other hand, via a protective diode (D1) to the drain electrode (D) of the MOSFET power transistor (T1), in that the first electrode of the protective diode (D1) is formed by the semiconductor body in the form of a wafer and the second electrode of the protective diode (D1) is formed by a further zone (5) having the opposite conductivity type to that of the semiconductor body (100), which further zone is diffused into the semiconductor body (100) from the first main surface.

9. Circuit arrangement according to Claim 8, characterized in that the zone (5) forming the second electrode of the protective diode (D1) has the same doping of the second conductivity type as the zone forming the protective ring (4) .

10. Circuit arrangement according to Claim 8 or 9, characterized in that a first zener diode (D2) is provided for protecting the gate of the MOSFET power transistor (T1) against overvoltages, in that, in order to form the first zener diode (D2), a further zone (13) having the conductivity type of the semiconductor body but an increased impurity concentration is diffused into the protective ring (4), the further zone (13) forming one electrode and the protective ring (4) forming the other electrode of the first zener diode (D2).

11. Circuit arrangement according to one of Claims 8 to 10, characterized in that a second zener diode (D3) is provided for protecting the gate of the MOSFET auxiliary transistor (T2) against overvoltages, in that, in order to form the second zener diode (D3), a further zone (14) having the conductivity type of the semiconductor body but an increased impurity concentration is diffused into the protective ring (4), and in that the further zone (14) forms one electrode and the protective ring (4) the other electrode of the second zener diode (D3).

12. Circuit arrangement according to Claim 1, characterized in that the MOSFET power transistor (T1) is designed as a SENSEFET power transistor in that at least one of its transistor elements is provided with a separate source terminal.

13. Circuit arrangement according to one of Claims 1 to 12, characterized in that at least one non-reactive resistor (R1, R21, R22) is accommodated as a diffused resistor in the protective ring (4) and has the conductivity type of the semiconductor body (100) but an increased impurity concentration.

14. Circuit arrangement according to one of Claims 1 to 13, characterized in that at least one non-reactive resistor (R1, R21, R22) consists of polysilicon and is accommodated in the plane of the polysilicon gate (9) of the MOSFET power transistor (T1).

15. Circuit arrangement according to one of Claims 1 to 14, characterized by at least one capacitor (C1), one plate (10) of which consists of polysilicon and is accommodated in the plane of the polysilicon gate (9) of the MOSFET power transistor (T1), and the other plate of which is formed at least partially by the protective ring (4).

## Revendications

1. Circuit intégré monolithique, qui est logé dans un corps semi-conducteur (100) en silicium, monocristallin, en forme de disque, présentant une première et une seconde surface principale, corps d'un premier type de conductibilité, avec un transistor de puissance MOSFET vertical (T1), en égard à la zone de drain qui s'étend de la première surface principale à la seconde surface principale et est pourvu sur la seconde surface principale d'un drain qui va de bout en bout (D), dans le cas duquel à partir de la première surface principale (13) on diffuse dans le corps semi-conducteur (100) au moins une zone (K) d'un corps d'un second type de conductibilité opposé au corps semi-conducteur, dans le cas duquel on diffuse dans au moins l'une des zones de corps (K), à partir de la première surface principale (13) respectivement au moins une zone de source (3) du type de conductibilité du corps semi-conducteur, mais avec une concentration plus élevée en impuretés et dans le cas duquel on prévoit au moins une porte en polysilicium (9) pour former le canal de conductibilité (12) et avec une bague de protection (4) entourant le transistor de puissance MOSFET (T1) du type de conductibilité d'au moins l'une des zones de corps (K), en diffusant dans la bague de protection (4), à partir de la première surface principale (13) d'autres zones (7, 8 13, 14) pour constituer au moins un élément périphérique de circuit (T2 ; D2 ; D3),
caractérisé en ce que
l'on prévoit comme élément périphérique de circuit au moins un transistor auxiliaire latéral MOSFET (T2), la bague de protection (4) servant de zone de corps (4) pour le transistor auxiliaire latéral MOSFET (T2), la zone de source (7) et la zone de drain (8) du transistor auxiliaire MOSFET (T2) du premier type de conductibilité présentant le même dopage qu'au moins l'une des zones de source (3) du transistor de puissance MOSFET (T1) et étant constituées dans la bague de protection (4) au voisinage l'une de l'autre et l'électrode de porte (10) du transistor auxiliaire MOSFET (T2) s'étendant sur la zone de la bague de protection (4), qui se trouve entre la zone de source (7) et la zone de drain (8), région dans laquelle se forme lors du fonctionnement le canal de conductibilité (20) du transistor auxiliaire MOSFET (T2) sur la première surface principale (13) du corps semi-conducteur (100).

2. Circuit selon la revendication 1,
caractérisé en ce que
la zone du corps (K) du transistor de puissance MOSFET (T1) est formée par une zone de petite surface (1) et une zone de plus grande surface (1a), la zone de plus petite surface (1) ayant une concentration de dopage plus élevée et la zone de surface plus grande (1a) ayant une concentration de dopage plus basse que la zone de protection (4) et les deux zones de surfaces différentes mentionnées (1, 1a), qui se superposent à la zone du corps (K), diffusant l'une dans l'autre, de telle façon que la zone de plus grande surface (1a) surplombe de tous les côtés la zone de surface plus petite (1).

3. Circuit selon la revendication 1 ou 2,
caractérisé en ce que
le transistor de puissance MOSFET (T1) consiste en une multiplicité de transistors partiels montés en parallèle les uns par rapport aux autres, dont chacun a une zone de corps (K) et au moins une zone de source (3), mais tous les transistors partiels ayant une zone de drain commune, qui est formée par la région du corps semi-conducteur (100) restante, non sollicitée par les zones du corps (K), délimitée par la bague de protection (4).

4. Circuit selon la revendication 1,
caractérisé en ce que
la bague de protection (4) vient en recouvrement dans la zone, dans laquelle elle reçoit le transistor auxiliaire MOSFET (T2), avec la zone du corps (K) de la cellule la plus extérieure, qui la jouxte, du transistor de puissance MOSFET (T1).

5. Circuit selon la revendication 4,
caractérisé en ce que
la zone de source (7) du transistor auxiliaire MOSFET (T2) est complètement noyée dans la zone du corps (K) de la cellule du transistor de puissance MOSFET (T1) la plus extérieure, qui la jouxte,
et en ce que
la zone de drain (8) du transistor auxiliaire MOSFET (T2) se trouve dans la zone qui est en dehors de cette zone de corps (K), de telle sorte que la zone de bordure (la) de la zone de corps (K) mentionnée du transistor de puissance MOSFET (T1) s'étende jusque dans la zone du canal du transistor auxiliaire MOSFET (T2).

6. Circuit selon la revendication 4,
caractérisé en ce que
la zone de source (7) du transistor auxiliaire MOSFET (T2) est en partie noyée dans la zone de corps (K), en recouvrement avec la bague de protection (4) de la cellule la plus extérieure, qui la jouxte, du transistor de puissance MOSFET (T1).

7. Circuit selon la revendication 5 ou 6,
caractérisé en ce que
la zone de source (7) du transistor auxiliaire MOSFET (T2) est mise en court-circuit avec la zone de source (3) de la cellule la plus extérieure, qui la jouxte, du transistor de puissance MOSFET (T1) et avec la bague de protection (4) au moyen de la métallisation de la source (S) du transistor de puissance MOSFET (T1).

8. Circuit selon la revendication 7,
caractérisé en ce que
l'électrode de drain du transistor auxiliaire MOSFET (T2) est reliée d'une part directement à l'électrode de porte du transistor de puissance MOSFET (T1) et d'autre part, par l'intermédiaire d'une première résistance ohmique (R1) à la borne d'entrée (G) du transistor de puissance MOSFET (T1),
en ce que
l'électrode de porte du transistor auxiliaire MOSFET (T2) est reliée d'une part par l'intermédiaire d'une seconde résistance ohmique (R21) à la borne d'entrée mentionnée (G) et d'autre part par l'intermédiaire d'une diode de protection (D1) à l'électrode de drain (D) du transistor de puissance MOSFET (T1),
en ce que
la première électrode de la diode de protection (D1) est constituée par une autre zone (5) que l'on a fait diffuser à partir de la première surface principale dans le corps semi-conducteur (100) d'un type de conductibilité opposé par rapport au corps semi-conducteur 100.

9. Circuit selon la revendication 8,
caractérisé en ce que
la zone (5) qui constitue la seconde électrode de la diode de protection (D1) présente le même dopage du second type de conductibilité que la zone qui constitue la bague de protection (4).

10. Circuit selon la revendication 8 ou 9,
caractérisé en ce qu'
on diffuse une première diode Zener (D2) pour protéger la porte du transistor de puissance MOSFET (T1) contre des surtensions,
en ce que
pour former la première diode Zener (D2) on diffuse une autre zone (13) avec le type de conductibilité du corps semi-conducteur, mais avec une concentration accrue en impuretés dans la bague de protection (4), l'autre zone (13) formant l'une des électrodes et la bague de protection (4) formant l'autre électrode de la première diode Zener (D2).

11. Circuit selon l'une des revendications 8 à 10,
caractérisé en ce que
l'on prévoit une seconde diode Zener (D3) pour protéger la porte du transistor auxiliaire MOSFET (T2) contre des surtensions,
en ce que
pour former la seconde diode Zener (D3) on diffuse une autre zone (14) avec le type de conductibilité du corps semi-conducteur, mais avec une concentration accrue en impuretés dans la bague de protection (4),
et en ce que
l'autre zone (14) forme l'une des électrodes et la bague de protection (4) forme l'autre électrode de la seconde diode Zener (D3).

12. Circuit selon la revendication 1,
caractérisé en ce que
le transistor de puissance MOSFET (T1) est constitué comme un transistor de puissance SENSEFET, en prévoyant au moins l'un de ses transistors partiels avec un raccord de source séparé.

13. Circuit selon l'une des revendications 3 à 12,
caractérisé en ce qu'
au moins une résistance ohmique (R1, R21, R22) est logée comme résistance diffusée dans la bague de protection (4) et présente le type de conductibilité du corps semi-conducteur (100), mais une concentration accrue en impuretés.

14. Circuit selon l'une des revendications 1 à 13,
caractérisé en ce qu'
au moins une résistance ohmique (R1, R21, R22) est en polysilicium et est logée dans le plan de la porte en polysilicium (9) du transistor de puissance MOSFET (T1).

15. Circuit selon l'une des revendications 1 à 14,
caractérisé par
au moins une capacité (C1) dont une couche (10) est en polysilicium, et est logée dans le plan de la porte en polysilicium (9) du transistor de puissance MOSFET (T1) et dont l'autre couche est formée au moins par la bague de protection (4).
